# EUROPEAN PATENT APPLICATION

(11) **EP 3 878 678 A1**
(43) Date of publication of application: **15.09.2021**
(21) Application number: 19883248.7
(22) Date of filing: 22.04.2019
(51) Int. Cl.: B60K 37/06, B60R 16/023

(54) **HUMAN-MACHINE INTERACTION APPARATUS AND VEHICLE**

(30) Priority: 09.11.2018 CN 201811334271
(71) Applicant: Kostal (Shanghai) Management Co., Ltd., Shanghai 201814 (CN); Shanghai Kostal-Huayang Automotive Electric Co., Ltd., Shanghai 201814 (CN)
(72) Inventor: WANG, Lijun, Shanghai 201814 (CN); WU, Jianwei, Shanghai 201814 (CN); SHI, Linrong, Shanghai 201814 (CN)
(74) Representative: Witte, Weller & Partner Patentanwälte mbB
(86) International application number: PCT/CN2019/083621
(87) International publication number: WO 2020/093661

(57) **Abstract**

A human-machine interaction apparatus and a vehicle comprising same. The human-machine interaction apparatus comprises: a first magnetic component (1) fixed on a device where the human-machine interaction apparatus is located, and has a preset surface area; a manipulation module (2) for generating a manipulation instruction; a data transmission module (3) for sending the manipulation instruction to a master controller of the device where the human-machine interaction apparatus is located for implementing a corresponding manipulation action; and a second magnetic component (4) connected to the manipulation module (2) and the data transmission module (3), and used for attaching same to the first magnetic component (1) to change the attachment position. A user can control the second magnetic component (4) to move to the appropriate position on the first magnetic component (1), and then perform human-machine interaction by means of the human-machine interaction apparatus, thereby avoiding the use inconvenience caused by the incapability of touching the human-machine interaction apparatus. The human-machine interaction apparatus can be manipulated in a normal attitude, the comfort is improved, and the user experience is good.

## Description

### CROSS REFERENCE OF RELATED APPLICATION

The present application claims priority to Chinese Patent Application No. 201811334271.5, titled "HUMAN-MACHINE INTERACTION APPARATUS AND VEHICLE", filed on November 09, 2018 with the China National Intellectual Property Administration, which is incorporated herein by reference in its entirety.

### FIELD

The present disclosure relates to the technical field of human-computer interaction, and in particular to a human-computer interaction apparatus and a vehicle including the same.

### BACKGROUND

A human-computer interaction apparatus is a common control apparatus in our daily life. For example, human-computer interaction apparatuses such as buttons or knobs are installed near a car seat to achieve functions such as controlling car audio or car air conditioning. Another example is buttons for selecting a floor in an elevator. However, due to fixed positions of these human-computer interaction apparatuses in conventional technology, a user cannot easily access some of remote human-computer interaction apparatuses in some cases. For example, a driver in a driving position of a car cannot access buttons in front of a front passenger seat, and children cannot access buttons on the car or elevator because of their small size. This brings obstacles to the use of the human-computer interaction apparatus, and a posture of the user has to be greatly changed to control the human-computer interaction apparatus, which reduces the comfort, and the user experience is poor.

Therefore, how to provide a solution to the above-mentioned technical problems is an issue that those skilled in the art need to address at present.

### SUMMARY

An objective of the present disclosure is to provide an apparatus for human-computer interaction, which makes it more convenient for a user to operate in a normal posture, and improves the comfort of operation. Another objective of the present disclosure is to provide a vehicle including the above an apparatus for human-computer interaction, which makes it more convenient for the user to operate the apparatus for human-computer interaction in the normal posture, and improves the comfort of operation.

To solve the above technical problems, an apparatus for human-computer interaction is provided according to an embodiment of the present disclosure, and the apparatus includes:
a first magnetic component with a preset surface area, fixed on a device where the apparatus for human-computer interaction is located;
a control module, configured to generate a control instruction;
a data transmission module, configured to send the control instruction to a main controller of the device where the apparatus for human-computer interaction is located, so as to implement a corresponding control action; and
a second magnetic component connected to the control module and the data transmission module, configured to attract the control module and the data transmission module to the first magnetic component, wherein an attraction position is changeable.

In another embodiment of the present disclosure, the second magnetic component includes:
a housing, configured to fix the control module and the data transmission module; and
a magnet embedded in the housing, configured to magnetically attract the control module, the data transmission module, and the housing to the first magnetic component.

In another embodiment of the present disclosure, the control module includes:
a knob;
an angle sensor, configured to acquire a rotation angle of the knob; and
a processor, configured to generate a corresponding control instruction according to the rotation angle.

In another embodiment of the present disclosure, the apparatus further includes:
a feedback prompting device, configured to give a feedback prompt under control of the processor after the processor successfully generates the control instruction.

In another embodiment of the present disclosure, the feedback prompting device is a vibration feedback prompting device.

In another embodiment of the present disclosure, the data transmission module is a wireless transmission module.

In another embodiment of the present disclosure, the wireless transmission module is a Bluetooth module.

In another embodiment of the present disclosure, the first magnetic component is a magnetic substrate.

In another embodiment of the present disclosure, the apparatus further includes:
a traction device, configured to pull the second magnetic component to move on the first magnetic component, so as to control the control module.

To solve the above technical problems, a vehicle is further provided according to an embodiment of the present disclosure, and the vehicle includes the apparatus for human-computer interaction according to any one of the foregoing embodiments.

An apparatus for human-computer interaction is provided according to embodiments of the present disclosure. The apparatus includes a first magnetic component, a control module, a data transmission module and a second magnetic component. The first magnetic component has a preset surface area and is fixed on a device where the apparatus for human-computer interaction is located. The control module is configured to generate a control instruction. The data transmission module is configured to send the control instruction to a main controller of the device where the apparatus for human-computer interaction is located, so as to implement a corresponding control action. The second magnetic component is connected to the control module and the data transmission module, and is configured to attract the control module and the data transmission module to the first magnetic component, where an attraction position is changeable.

It can be seen in the embodiments of the present disclosure, the control module controlled by the user is configured to generate the control instruction first, and the data transmission module is configured to send the control instruction to the main controller of the device where the apparatus for human-computer interaction is located, so as to implement the corresponding control action, where the second magnetic component attracts the control module and the data transmission module to the first magnetic component. Since the first magnetic component has the preset surface area, the user may control the second magnetic component to move to a suitable position on a surface of the first magnetic component and perform human-computer interaction through the apparatus for human-computer interaction, avoiding usage barriers caused by the user's inaccessibility of the apparatus for human-computer interaction. Therefore, the user can control the apparatus for human-computer interaction in a normal posture, which improves the comfort of operation and brings a good user experience.

The vehicle provided according to the embodiment of the present disclosure has similar beneficial effects as the foregoing apparatus for human-computer interaction.

### BRIEF DESCRIPTION OF THE DRAWINGS

For clearer illustration of the technical solutions according to embodiments of the present disclosure or conventional techniques, hereinafter briefly described are the drawings to be applied in embodiments of the present disclosure or conventional techniques. Apparently, the drawings in the following descriptions are only some embodiments of the present disclosure, and other drawings may be obtained by those skilled in the art based on the provided drawings without creative efforts.
Figure 1 is a schematic structural diagram of an apparatus for human-computer interaction according to an embodiment of the present disclosure;
Figure 2 is a top view of an apparatus for human-computer interaction according to an embodiment of the present disclosure; and
Figure 3 is a schematic structural diagram of an apparatus for human-computer interaction according to another embodiment of the present disclosure.

### DETAILED DESCRIPTION

The core of the present disclosure is to provide an apparatus for human-computer interaction, which makes it more convenient for a user to operate in a normal posture, and improves the comfort of operation. Another core of the present disclosure is to provide a vehicle including the above apparatus for human-computer interaction, which makes it more convenient for the user to operate the apparatus for human-computer interaction in the normal posture, and improves the comfort of operation.

In order to help those skilled in the art better understand solutions of the present disclosure, hereinafter technical solutions in embodiments of the present disclosure are described clearly and completely in conjunction with the drawings in embodiments of the present disclosure. Apparently, the described embodiments are only some rather than all of the embodiments of the present disclosure. Any other embodiments obtained based on the embodiments of the present disclosure by those skilled in the art without any creative effort fall within the scope of protection of the present disclosure.

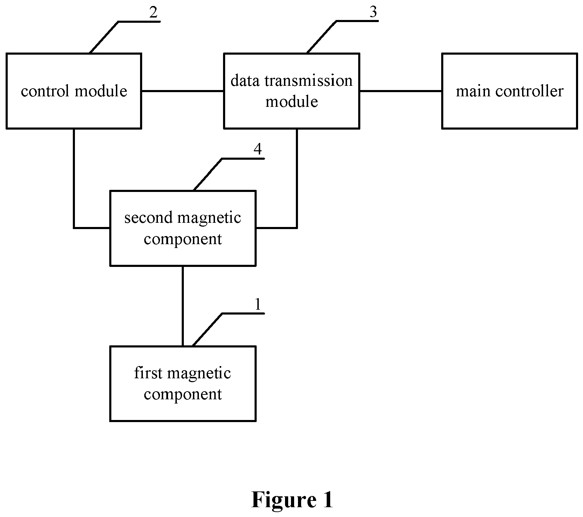

Reference is made to Figure 1, which is a schematic structural diagram of an apparatus for human-computer interaction according to an embodiment of the present disclosure. The apparatus includes a first magnetic component 1, a control module 2, a data transmission module 3 and a second magnetic component 4.

The first magnetic component 1 has a preset surface area and is fixed on a device where the apparatus for human-computer interaction is located. The control module 2 is configured to generate a control instruction. The data transmission module 3 is configured to send the control instruction to a main controller of the device where the apparatus for human-computer interaction is located, so as to implement a corresponding control action. The second magnetic component 4 is connected to the control module 2 and the data transmission module 3, and is configured to attract the control module 2 and the data transmission module 3 to the first magnetic component 1, where an attraction position is changeable.

Specifically, having considered the technical problems mentioned in the background part, the second magnetic component 4 is magnetically attracted to the first magnetic component 1 and is connected to the control module 2 and the data transmission module 3, and the attraction position may be changed by the user in the embodiment of the present disclosure. Therefore, a distance between the control module 2 and the user may be changed by changing the attraction position of the second magnetic component 4, so that the control module 2 may be operated without changing the user's normal posture, which improves the comfort of operation and ensures normal use of human-computer interaction functions.

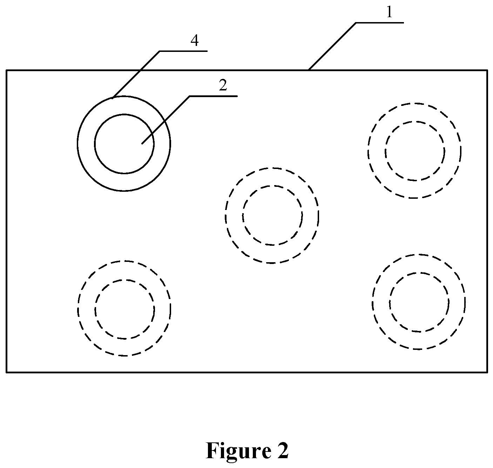

In order to better introduce the apparatus for human-computer interaction provided by the embodiment of the present disclosure, reference is made to Figure 2, which is a top view of an apparatus for human-computer interaction according to an embodiment of the present disclosure. The first magnetic component 1 is a rectangle as shown in Figure 2, and the preset surface area is a product of a length and a width of the rectangle. The control module 2, the data transmission module 3 and the second magnetic component 4 may be moved as a whole in various directions on the surface of the first magnetic component 1. For example, as shown in Figure 2, the control module 2, the data transmission module 3 and the second magnetic component 4 that are on the first magnetic component 1 may be moved as a whole to the dotted circle area. Apparently, the control module 2, the data transmission module 3 and the second magnetic component 4 may also be moved to other positons on the surface of the first magnetic component 1. To clarify, the data transmission module 3 cannot be visually seen in Figure 2.

In an embodiment of the present disclosure, the first magnetic component 1 may be fixed on the device where the apparatus for human-machine interaction is located, so as to provide support and operation space for the control module 2, the data transmission module 3 and the second magnetic component 4. The preset surface area of the first magnetic component 1 may be set independently, for example, 40 square centimeters, etc. The positon of the second magnetic component 4 on the surface of the first magnetic component 1 may be easily changed with a large operation space, which further improves the operation comfort of the apparatus for human-machine interaction.

In an embodiment of the present disclosure, the control module 2 may be of multiple types, which can be used by the user to generate the control instruction, for example, control instructions for elevator floor selection or car audio volume adjustment, etc. The control module 2 may be an existing control module type, or other types, which is not limited in the embodiments of the present disclosure.

In an embodiment of the present disclosure, the data transmission module 3 may send the control instruction generated by the control module 2 to the main controller of the device where the apparatus for human-computer interaction is located, so as to implement the corresponding control action. In a device such as an elevator or a car, an original apparatus for human-computer interaction includes a controller. In the embodiment of the present disclosure, the main controller of the device where the apparatus for human-computer interaction is located may be used to process the control instruction of the apparatus for human-computer interaction. Therefore, there is no need to add additional devices, which avoids additional costs.

In an embodiment of the present disclosure, the first magnetic component 1 and the second magnetic component 4 may be of multiple types. For example, the first magnetic component 1 may be a metal with magnetism, such as iron, and the second magnetic component 4 may be a magnet. Apparently, the first magnetic component 1 and the second magnetic component 4 may also be other types, which is not limited in the embodiments of the present disclosure.

In an embodiment of the present disclosure, the second magnetic component 4 may be connected to the control module 2 and the data transmission module 3, and the control module 2, the data transmission module 3 and the second magnetic component 4 may be attracted to any position of the first magnetic component 1 as a whole by the second magnetic component 4. In this case, the user can arbitrarily change the position of the control module 2, the data transmission module 3 and the second magnetic component 4 as a whole on the first magnetic component 1 to facilitate the operation of the control module 2. For example, when the first magnetic component 1 is a magnetic substrate, the user can freely adjust the position of the second magnetic component 4 on the magnetic substrate, for instance, the second magnetic component 4 may be located in an upper left corner, middle or a lower right corner of the magnetic substrate. Apparently, the second magnetic component 4 may also be removed from the magnetic substrate for operation, which is not limited in the embodiments of the present disclosure.

In an embodiment of the present disclosure, the preset surface area may be set to a size required by the scene. If the preset surface area is too large, it is not conducive to the settings other devices, and if the preset surface area is too small, it is not easy to flexibly change the position.

The apparatus for human-computer interaction is provided according to embodiments of the present disclosure. The apparatus includes the first magnetic component, the control module, the data transmission module and the second magnetic component. The first magnetic component has the preset surface area and is fixed on the device where the apparatus for human-computer interaction is located. The control module is configured to generate the control instruction. The data transmission module is configured to send the control instruction to the main controller of the device where the apparatus for human-computer interaction is located, so as to implement the corresponding control action. The second magnetic component is connected to the control module and the data transmission module, and is configured to attract the control module and the data transmission module to the first magnetic component, where the attraction position is changeable.

It can be seen in the embodiments of the present disclosure, the control module controlled by the user is configured to generate the control instruction first, and the data transmission module is configured to send the control instruction to the main controller of the device where the apparatus for human-computer interaction is located, so as to implement the corresponding control action, where the second magnetic component attracts the control module and the data transmission module to the first magnetic component. Since the first magnetic component has the preset surface area, the user may control the second magnetic component to move to a suitable position on a surface of the first magnetic component and perform human-computer interaction through the apparatus for human-computer interaction, avoiding usage barriers caused by the user's inaccessibility of the apparatus for human-computer interaction. Therefore, the user can control the apparatus for human-computer interaction in a normal posture, which improves the comfort of operation and brings a good user experience.

In another embodiment of the present disclosure provided on the basis of the above embodiments of the present disclosure, the second magnetic component 4 includes a housing 41 and a magnet 42. The housing 41 is configured to fix the control module 2 and the data transmission module 3. The magnet 42 is embedded in the housing 41 and is configured to magnetically attract the control module 2, the data transmission module 3, and the housing 41 to the first magnetic component 1, where the attraction position is changeable.

Specifically, the housing 41 may play a role of fixing the control module 2 and the data transmission module 3, so that the control module 2 and the data transmission module 3 are more integrated, which is convenient to improve the service life thereof. In addition, the housing 41 may further play a role of packaging and decorating the control module 2 and the data transmission module 3, so that the second magnetic component 4, the control module 2 and the data transmission module 3 are more integrated, which is easy for the user to control.

In an embodiment of the present disclosure, the magnet 42 has good adsorption properties. Embedding the magnet 42 in the housing 41 can further improve the integrity of the second magnetic component 4, the control module 2 and the data transmission module 3. In addition, the magnet 42 has the advantages of low price and simple structure.

In addition to the specific type of the second magnetic component 4 provided in this embodiment, the second magnetic component 4 may also be of other types, which is not limited in the embodiment of the present disclosure.

Therefore, the user can not only easily control the entire composition of the second magnetic component 4, the control module 2 and the data transmission module 3, but also easily remove it from the first magnetic component 1 for operation, thereby further improving the comfort.

In another embodiment of the present disclosure, the control module 2 includes a knot 21, an angle sensor 22 and a processor 23. The angle sensor 22 is configured to acquire a rotation angle of the knot 21. The processor is configured to generate a corresponding control instruction according to the rotation angle.

Specifically, the knot 21 is a tool through which the user may issue an instruction. In this embodiment of the present disclosure, the user may rotate different rotation angles through the knot 21. After the different rotation angles are acquired by the angle sensor 22, the processor 23 may generate the corresponding control instruction according to the different angles. For example, in a car, when the user rotates a rotation angle of 10 degrees through the knob 21, the processor 23 generates an instruction to turn on the lights, and when the user rotates a rotation angle of 20 degrees through the knob 21, the processor 23 generates an instruction to turn off the lights, which is not limited in the embodiments of the present disclosure.

In an embodiment of the present disclosure, different scale lines and instruction prompts may also be set on the knob 21, so that the user can use the control module 2 quickly and skillfully.

In an embodiment of the present disclosure, the angle sensor 22 may be of multiple types, which is not limited in the embodiment of the present disclosure.

In an embodiment of the present disclosure, the processor 23 may be of multiple types, and a relationship between the rotation angle and the corresponding control instruction may be edited in advance, or may be changed when necessary, which is not limited in the embodiment of the present disclosure.

In addition to the specific type of the control module 2 provided in this embodiment of the present, the control module 2 may also be of other types. For example, an object for the user to make an action may be a button, and the user may issue the corresponding instruction by pressing or touching the button. The angle sensor may also be replaced by other types of sensors or a combination of multiple different types of sensors. In an example, a pressure sensor is used to detect a pressure, and the processor 23 determines the corresponding control instruction when the detected pressure reaches a preset pressure threshold. In another example, a combination of an angle sensor and a speed sensor is used for detecting, the processor 23 compares rotation angle obtained from the angle sensor and rotation speed obtained from the speed sensor with a preset angle threshold and a preset speed threshold respectively, to determine the corresponding control instruction. For example, a control instruction A may be generated in a case that the rotation angle is 30 degrees and the obtained rotation speed reaches the preset speed threshold, which is not limited in the embodiment of the present disclosure.

In an embodiment of the present disclosure, specific values of preset thresholds may be of various types, for example, 10 meters per second, etc., which is not limited in the embodiment of the present disclosure.

In another embodiment of the present disclosure, the apparatus for human-computer interaction further includes a feedback prompting device 5. The feedback prompting device 5 is configured to give a feedback prompt under control of the processor 23 after the processor 23 successfully generates the control instruction.

Specifically, in a case that the user does not look directly at the control module 2 when operating the control module 2, the user may be not able to know for sure whether standardized operation for generating the control instruction is completed. In the embodiment of the present disclosure, the feedback prompting device 5 may provide the feedback prompt under the control of the processor 23 after the processor 23 successfully generates the control instruction. In such case, after receiving the feedback prompt, the user may know that the control action has been correctly completed and the control instruction has been generated, which further improves the comfort of using the apparatus for human-computer interaction and is more user-friendly.

In an embodiment of the present disclosure, when the user has rotated the knob 21 by 30 degrees for generating a control instruction of turning on the music, even if the user thinks that rotated the correct angle has been rotated, the music may not be controlled to be turned on if there is no feedback prompting device 5. In this embodiment of the present disclosure, in a case that there is the feedback prompting device 5, when the processor 23 generates the control instruction of turning on the music, the feedback prompting device 5 will prompt the user, and the user may know in real time whether the operation is successful, which can improve the efficiency of the apparatus for human-computer interaction.

In another embodiment of the present disclosure, the feedback prompting device 5 is a vibration feedback prompting device 5.

Specifically, the vibration feedback prompting device 5 has the advantages of simple structure, low price and good prompting effect.

The vibration feedback prompting device may include a motor driver and a vibration motor. When a vibration feedback prompt is required, the processor 23 may control the vibration motor to vibrate for a certain time through the motor driver, such as 0.05s, to complete a vibration feedback prompt. Apparently, the vibration feedback prompting device 5 may also be of other types, which is not limited herein.

In addition to the vibration feedback prompting device 5, the feedback prompting device 5 may also be of other types, such as light or sound and like, which is not limited herein.

In another embodiment of the present disclosure, the data transmission module 3 is a wireless transmission module.

Specifically, the wireless transmission module has the advantages of simple wiring, simple structure and small size.

The data transmission module 3 may also be a wired transmission module, which is not limited herein.

In another embodiment of the present disclosure, the wireless transmission module is a Bluetooth module.

Specifically, the Bluetooth module has the advantages of stable transmission, simple structure and long service life.

In addition to the Bluetooth module, the wireless transmission module may also be of other types, such as wireless radio frequency transmission, WIFI (Wireless-Fidelity) or infrared transmission module, etc., which is not limited herein.

In another embodiment of the present disclosure, the first magnetic component 1 is a magnetic substrate.

Specifically, due to the shape of the magnetic substrate, it is easy to be installed on various types of devices, such as a position of the center control panel of a car, etc. It also has the advantages of high durability and convenient operation.

The magnetic substrate may be a single-layer magnetic board, or a double-layer board. A bottom layer of the double-layer board is a bottom plate without magnetic material and an upper layer of the double-layer board of the double-layer board. Apparently, the magnetic substrate may also be with other structures, which is not limited herein.

In addition to the magnetic substrate, the first magnetic component 1 may be of other shapes, which is not limited herein.

In another embodiment of the present disclosure, the apparatus for human-computer interaction further includes a traction device, which is used to pull the second magnetic component 4 to move on the first magnetic component 1, so as to control the control module 2.

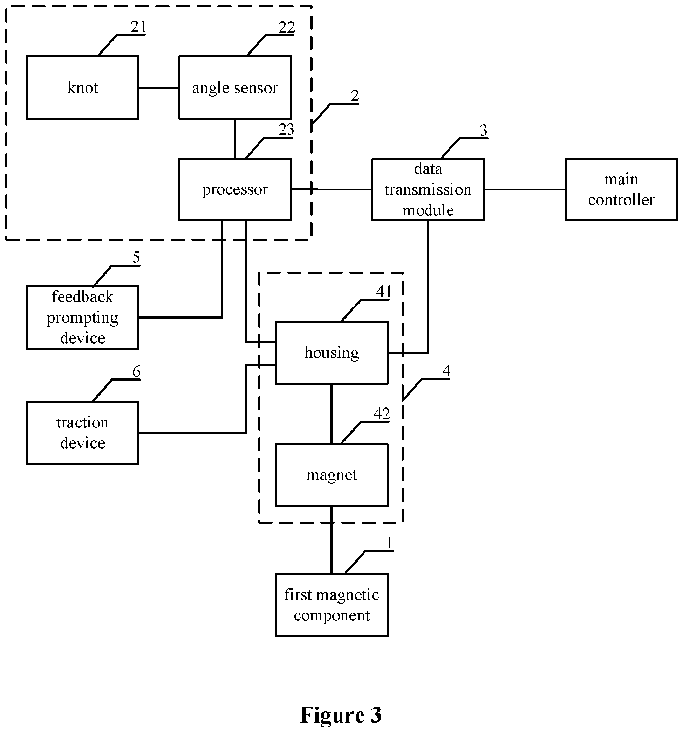

Reference is made to Figure 3, which is a schematic structural diagram of an apparatus for human-computer interaction according to another embodiment of the present disclosure.

Specifically, the traction device 6 may be installed on any position of a whole of the second magnetic component 4, the control module 2 and the data transmission module 3. The user may change the attraction position of the second magnetic component 4 on the first magnetic component 1 by pulling the traction device 6 to change the position of the whole, so as to facilitate the operation. For example, if the driver in the driving positon in the car needs to operate the control module 2 which is currently in front of the front passenger seat, the driver cannot access the whole mentioned-above to change the attraction position in a case that there is no traction device 6, however, in a case that the driver can easily access the traction device 6, the driver can use the traction device 6 to change the attraction position of the second magnetic component 4 to move the whole to his side for control.

In an embodiment of the present disclosure, the traction device 6 may be of other types, such as thin rod or a traction wire, which is not limited herein.

The traction device 6 may be provided in the housing 41 mentioned in the above embodiments, facilitating the change the attraction position of the whole of the second magnetic component 4, the control module 2 and the data transmission module 3.

To solve the above technical problems, a vehicle is further provided according to an embodiment of the present disclosure. The vehicle includes the apparatus for human-computer interaction according to any one of the above embodiments of the present disclosure.

For an introduction of the vehicle provided by this embodiment, the foregoing embodiments of the apparatus for human-computer interaction may be referred to, which is not limited herein.

The embodiments of the present disclosure are described in a progressive manner, and each embodiment places emphasis on the difference from other embodiments. Therefore, one embodiment can refer to other embodiments for the same or similar parts. It should be noted that, the relationship terms such as "first", "second" and the like are only used herein to distinguish one entity or operation from another, rather than to necessitate or imply that an actual relationship or order exists between the entities or operations. Furthermore, the terms such as "include", "comprise" or any other variants thereof means to be non-exclusive. Therefore, a process, a method, an article or a device including a series of elements include not only the disclosed elements but also other elements that are not clearly enumerated, or further include inherent elements of the process, the method, the article or the device. Unless expressively limited, the statement "including a..." does not exclude the case that other similar elements may exist in the process, the method, the article or the device other than enumerated elements.

The above description of the embodiments enables those skilled in the art to implement or use the present disclosure. Various modifications to these embodiments are apparent to those skilled in the art, and the general principle defined herein may be implemented in other embodiments without deviating from the spirit or scope of the present disclosure. Therefore, the present disclosure is not limited to these embodiments described herein, but in accordance with the widest scope consistent with the principle and novel features disclosed herein.

## Claims

1. An apparatus for human-computer interaction, comprising:
a first magnetic component with a preset surface area, fixed on a device where the apparatus for human-computer interaction is located;
a control module, configured to generate a control instruction;
a data transmission module, configured to send the control instruction to a main controller of the device where the apparatus for human-computer interaction is located, so as to implement a corresponding control action; and
a second magnetic component connected to the control module and the data transmission module, configured to attract the control module and the data transmission module to the first magnetic component, wherein an attraction position is changeable.

2. The apparatus according to claim 1, wherein the second magnetic component comprises:
a housing, configured to fix the control module and the data transmission module; and
a magnet embedded in the housing, configured to magnetically attract the control module, the data transmission module, and the housing to the first magnetic component.

3. The apparatus according to claim 2, wherein the control module comprises:
a knob;
an angle sensor, configured to acquire a rotation angle of the knob; and
a processor, configured to generate a corresponding control instruction according to the rotation angle.

4. The apparatus according to claim 3, further comprising:
a feedback prompting device, configured to give a feedback prompt under control of the processor after the processor successfully generates the control instruction.

5. The apparatus according to claim 4, wherein the feedback prompting device is a vibration feedback prompting device.

6. The apparatus according to claim 1, wherein the data transmission module is a wireless transmission module.

7. The apparatus according to claim 6, wherein the wireless transmission module is a Bluetooth module.

8. The apparatus according to claim 1, wherein the first magnetic component is a magnetic substrate.

9. The apparatus according to any one of claims 1 to 8, further comprising:
a traction device, configured to pull the second magnetic component to move on the first magnetic component, so as to control the control module.

10. A vehicle, comprising the apparatus for human-computer interaction according to any one of claims 1 to 9.
